# EUROPEAN PATENT SPECIFICATION

(11) **EP 1 137 186 B1**
(45) Date of publication and mention of the grant of the patent: **21.07.2004**
(21) Application number: 00105828.8
(22) Date of filing: 20.03.2000
(51) Int. Cl.: H03L 7/00

(54) **An adjustable spread spectrum clock generator and a method thereof**
Einstellbarer Taktgenerator mit spektraler Dispersion und Verfahren hierfür
Générateur d'horloge réglable à dispersion spectrale et méthode à cet effet

(43) Date of publication of application: 26.09.2001
(73) Proprietor: MOTOROLA, INC., Schaumburg, IL 60196 (US)
(72) Inventor: Refaeli, Moshe, 45287 Hod-Hasharon (IL); Afek, Yachin, Cfar-Sabe 44257 (IL); Fried, Norbert, 62507 Tel Aviv (IL); Smolyansky, Leonid, 30600 Or-Akiva (IL)
(74) Representative: Wray, Antony John

(56) References cited:
- US-A- 5 416 434
- US-A- 5 659 587
- US-A- 6 014 063

## Description

### Field of the invention

An adjustable spread spectrum clock generator and a method thereof.

### Background of the invention

Many electronic devices require at least one clock signal for synchronization. The generation of high frequency clock signals causes electromagnetic interferences that have peak amplitudes at the clock frequency and at its harmonics.

Spread spectrum clock generators reduce the amplitude of the electromagnetic interference components by spreading the clock frequency within a predetermined range of frequencies. Some prior art spread spectrum clock generators are illustrated at the following U.S. patents: 5,651,035 of Tozan et al.; 6,014,063 of Liu et al.; 5,872,807 of Booth et al.; 5,812,590 of Black et al.

Prior art solutions are adapted to handle a fixed clock signal having a predetermined clock frequency. Furthermore, prior art spread spectrum clock generators are characterized by fixed parameters. For example, Liu suggest to generate a spread spectrum clock by providing a clock signal to a plurality of delay lines, generating a plurality of delayed clock signals and selecting various delayed signals. The delay of the delay lines is fixed. This solution is also energy consuming, because many delay lines are activated even if the do not take part in the provision of a delayed clock signal. Liu further suggests spread spectrum clock generator that has a Current Controlled Oscillator, wherein the current to the CCO is either increased or decreased by a fixed amount. Booth describes a spread spectrum generator that is also very complex, and is limited to relatively slow variations in the clock frequency.

Prior art solutions are not adapted to compensate for variations of the clock frequency and/or in the behavior of the spread spectrum clock generator. The clock frequency can be changed, either intentionally or not. A clock frequency can be depended upon an operating mode of the device. The clock frequency can be lowered in order to save energy when the device operates at an idle mode or at a low energy consumption mode. Variations in the temperature of a device can alter the clock frequency and the spread spectrum clock generator behavior. Furthermore, component tolerances and process variations often result in wide variations in the clock frequency and in the characteristics of the spread spectrum clock generator.

Many modern devices are driven by at least two clock signals. For example, a single mobile phone can handle a plurality of cellular phone systems, such as GSM, JDC, PCN, PCS, AMPS, DECT and CDMA. Each system has its own operating frequency. Thus, such a cellular phone is driven by various clock signals having different frequencies. Designing a separate spread spectrum clock generator for each frequency is time consuming and complicates the design of the device. Therefor, there is a need to provide a reusable single spread spectrum clock generator block.

There is a need to provide an adjustable spread spectrum clock generator and a method thereof. There is a further need to provide an auto-calibrated spread spectrum generator for compensating for variations in the clock frequency or in the behavior of the spread spectrum clock generator.

### Brief description of the drawings

While the invention is pointed out with particularity in the appended claims, other features of the invention are disclosed by the following detailed description taken in conjunction with the accompanying drawings, in which:
FIG. 1 is a flow chart diagram of a method for generating a spread spectrum clock signal, according to a preferred embodiment of the invention;
FIG. 2 is a flow chart diagram of a method for generating a spread spectrum clock signal, according to another preferred embodiment of the invention
FIG. 3 is a schematic description of an apparatus for generating a spread spectrum clock signal, according to a preferred embodiment of the invention; and
FIG. 4 is a schematic description of a variable delay unit, according to a preferred embodiment of the invention.

### Detailed description of the drawings

It should be noted that the particular terms and expressions employed and the particular structural and operational details disclosed in the detailed description and accompanying drawings are for illustrative purposes only and are not intended to in any way limit the scope of the invention as described in the appended claims.

The invention provides an improved method that overcomes the disadvantages of the prior art methods by delaying a clock signal for a variable delay period, wherein the variable delay period is adjusted to handle various clock signal frequencies, and to compensate for changes in various parameters that influence the variable delay period.

The objectives of the invention are achieved by the method and apparatus for generating a spread spectrum clock signal as defined in claims 1 and 11, respectively.

The invention provides a method for generating spread spectrum clock signals, the method comprising the steps of: (1.a) determining a relationship R between a fundamental period T of a clock signal and a period offset DT; (1 .b) receiving a clock signal having the fundamental period T; (1.d) determining DT and producing a spread spectrum clock signal having a period that ranges between (T-DT) and (T+DT). DT is based upon T and R. The clock signal is delayed by a variable delay period. The variable delay period can be changed (a) each clock cycle, (b) randomly, (c) in a predetermined manner, (d) by a delay step DS, (e) by multiples of the delay step DS. DS is usually smaller than period offset DT and is much smaller than fundamental period T. Conveniently, the spread spectrum clock generation involves passing the clock signal through a variable delay line, for delaying the clock signal for a variable delay period.

The invention further provides a method for generating spread spectrum clock signals, the method further comprising step (1.c) of adjusting the delay step DS so that the spread spectrum clock signal to be produced during step (1.d) has a period that ranges between (T-DT) and (T+DT). Steps (1.c) and (1.d) can be repeated either constantly, in manner that compensated for either variations in the delay step, in the variable delay period and/or for changes in the fundamental period . The delay step and/or the behavior of the spread spectrum clock generator can vary when the temperature of the spread spectrum generator or the device that is coupled to it varies.

The invention provides a method for generating spread spectrum clock signal, the method involves an adjustment stage in which step (1.c) further comprising the steps of: (1.c.1) providing a clock signal to an adjustable delay line and generating a delayed clock signal, and (1.c.2) comparing the clock signal and the delayed clock signal and changing DS accordingly. Conveniently, the delayed clock signal is provided to a first counter and the clock signal is provided to a second counter.

The invention provides a method and apparatus for generating spread spectrum clock signal. The clock signal passed through a variable delay line having a variable delay period. The variable delay period of the variable delay line is controlled by a control word, and step (1.c) further comprises the steps of: (1.c.1) learning at least one control word CW that causes the variable delay line to delay the clock signal by at least a delay step DS; and (1.c.2) storing the at least one control word CW so that the at least one control word can be provided to the variable delay line during step (1.d). Step (1.c.1) can involve learning a set of control words that cause the variable delay line to delay the clock signal by multiples of DS.

Conveniently, the variable delay period is controlled by a combination of a basic set of control signals. Step (1.b) is followed by step (1.c) of learning and storing the basic set of control signals. Steps (1.c) and (1.d) can be repeated either constantly, in manner that compensated for either variations in the delay step, in the variable delay period and/or for changes in the fundamental period.

The invention provides a method and apparatus for generating spread spectrum clock signal. The variable delay period can be the sum of a plurality of delay sub-periods. The length of each delay sub-period is controlled by at least one basic control signal out of the basic set of control signals. The combination of the basic set of control can vary either each clock cycle, vary randomly or in a predetermined manner.

The invention provides an apparatus for generating a spread spectrum clock signal, the apparatus comprising : A variable delay line, for receiving a clock signal having a fundaments period T, delaying the clock signal for a variable delay period and providing the spread spectrum clock. A control unit, coupled to the variable delay line, for receiving a control parameter R, R defining a relationship between the fundamental period T and a period offset DT, the control unit is adapted to control the variable delay period of the variable delay line so that the spread spectrum clock has a period that ranges between (T-DT) and (T+DT). Conveniently, DT is much smaller than T, DT equals T*R.

The invention provides an apparatus for generating a spread spectrum clock signal, the apparatus further comprising a learning unit, coupled to the control unit, for receiving the clock signal and adjusting the delay step DS so that the spread spectrum clock signal to be produced during step (1.d) has a period that ranges between (T-DT) and (T+DT). The learning unit can be activated either constantly, in manner that compensated for either variations in the delay step, in the variable delay period and/or for changes in the fundamental period .

The invention provides an apparatus for generating a spread spectrum clock in which the control unit sends the variable delay line a plurality of control signals for determining the variable delay period. The learning unit is adapted to learn and to store at least one control word CW that causes the variable delay line to delay the clock signal by at least a delay step DS. The control word CW is further provided to the control unit and to the variable delay line. Conveniently, the learning unit is adapted to learn a set of control words that cause the variable delay line to delay the clock signal by multiples of DS.

The invention provides an apparatus for generating a spread spectrum clock wherein the variable delay period is controlled by a combination of a basic set of control signals. The learning unit is adapted to learn and store the basic set of control signals. The control unit receives the basic set of control signals from the learning unit and provides the combination of the basic set of control signals to the variable delay line.

The invention provides an apparatus for generating a spread spectrum clock wherein the variable delay line comprises of a plurality of serially coupled variable delay units, each variable delay unit delays a signal by a delay sub-period. The length of each delay sub-period is controlled by at least one basic control signal out of the basic set of control signals. The combination of the basic set of control signals is varied either constantly, in manner that compensated for either variations in the delay step, in the variable delay period and/or for changes in the fundamental period.

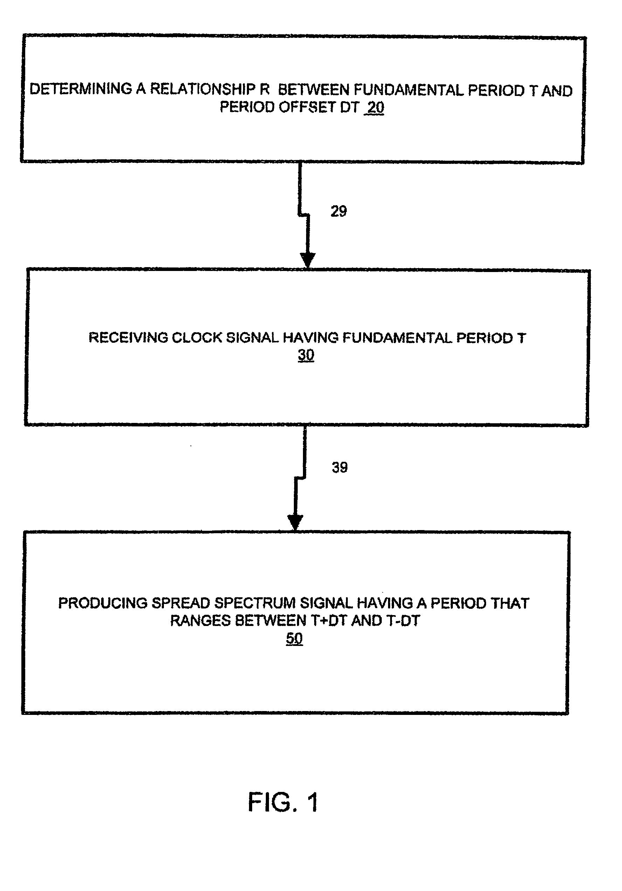

FIG. 1 is a flow chart diagram of method 10 for generating a spread spectrum clock signal, according to a preferred embodiment of the invention. Preferably, method 10 comprises steps 20, 30 and 50, all steps illustrated by blocks. Solid lines 29 and 39 coupling the steps indicate a preferred method flow.

Method 10 for generating spread spectrum clock signals, comprising the steps of: step 20 of determining a relationship R between a fundamental period T of a clock signal and a period offset DT. Step 30 of receiving a clock signal having the fundamental period T. Step 50 of producing a spread spectrum clock signal having a period that ranges between (T-DT) and (T+DT), DT being derived from fundamental period T and the predetermined relation R. Method 10 allows to generate a spread spectrum clock signal for various clock frequencies. Method 10 allows to design a reusable spread spectrum clock generator. Step 50 can jump to step 30 for checking the clock fundamental period and for adjusting the variable delay period in order to compensate for variations in the clock fundamental period. Conveniently, DT is much smaller than T in order to allow a proper operation of a device that receives the spread spectrum clock. DT typically is smaller than 0.01*T.

Step 50 involves delaying the clock signal by a variable delay period. The variable delay period is varied in order to spread the energy of the clock signal and its harmonics over a frequency range. The variable delay period can be varied (a) each clock cycle, (b) randomly, (c) in a predetermined manner, (d) by a delay step DS, (e) by multiples of the delay step DS. DS is usually smaller than period offset DT. Conveniently, step 50 involves passing the clock signal through a variable delay line, for delaying the clock signal for a variable delay period.

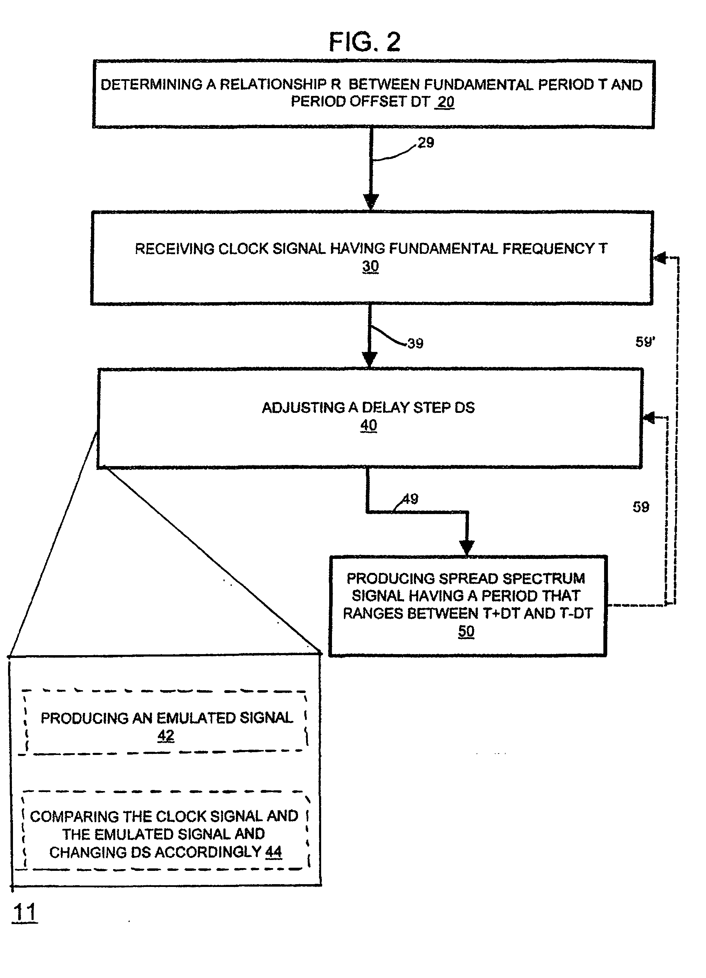

FIG.2 is a flow chart diagram of method 11 for generating a spread spectrum clock signal, according to another preferred embodiment of the invention. Preferably, method 10 comprises steps 20, 30, 40 and 50, all steps illustrated by blocks. Solid lines 29, 39, 49 and 59 coupling the steps indicate a preferred method flow.

Method 11 allows to compensate for variations the clock frequency and/or in the characteristics behavior of the spread spectrum clock generator. Method 11 is analogues to method 10 but has an additional step 40 of adjusting the delay step DS so that the spread spectrum clock signal to be produced during step 50 has a period that ranges between (T-DT) and (T+DT). Step 40 allows to compensate for variations the clock frequency and/or in the characteristics behavior of the spread spectrum clock generator. Conveniently, steps 40 and 50 are repeated constantly, so that method 11 allows constant compensations. If the variations in either delay step, fundamental frequency follow a predetermined pattern, or can be detected than steps 40 and 50 are to be repeated accordingly.

Step 40 further involves steps 42 and 44. Step 42 of generating a emulation signal by an emulator of the variable delay line, comparing the clock signal and the emulation signal and changing DS accordingly.

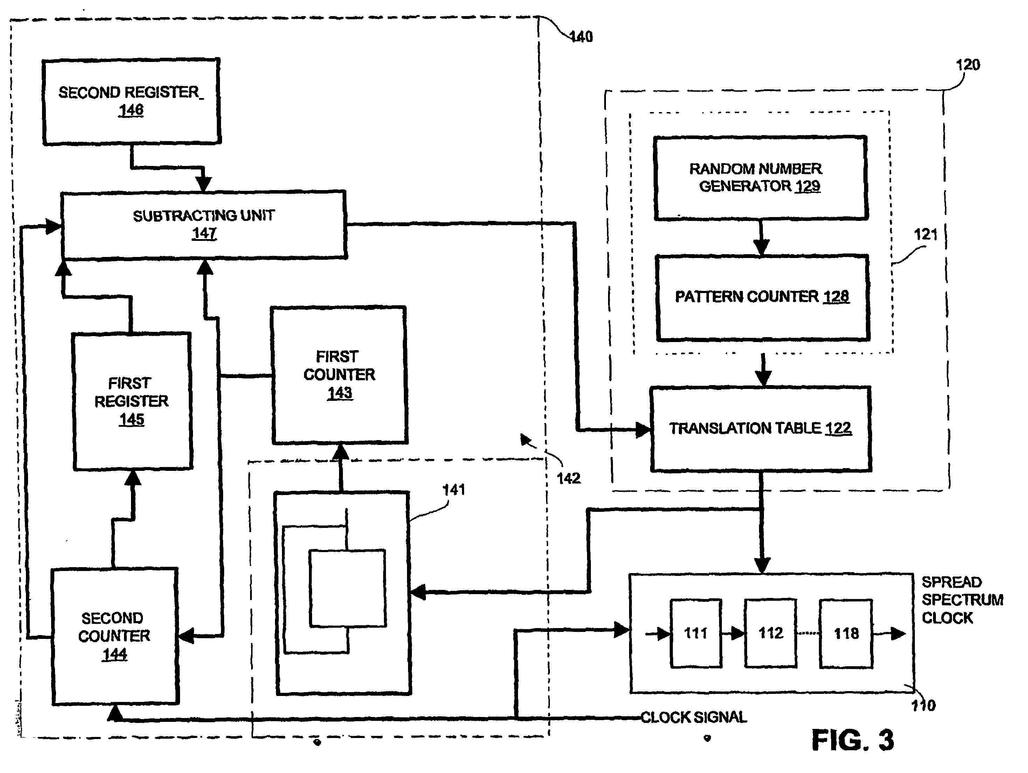

Conveniently, the emulated signal is provided to a first counter and the clock signal is provided to a second counter. Step 44 will be further explained in accordance with FIG. 3.

In another preferred embodiment of the invention step 50 involves passing the clock signal passed through a variable delay line having a variable delay period. The variable delay period of the variable delay line is controlled by a control word. Step 42 involves learning at least one control word CW that causes the variable delay line to delay the clock signal by at least a delay step DS. Step 44 involves storing the at least one control word CW so that the at least one control word can be provided to the variable delay line during step 50. Step 42 can also be implemented by learning a set of control words that cause the variable delay line to delay the clock signal by multiples of DS.

In yet another preferred embodiment of the invention, the variable delay period is controlled by a combination of a basic set of control signals. Step 40 involves learning and storing the basic set of control signals. Conveniently, steps 40 and 50 are repeated constantly, so that method 11 allows constant compensations. If the variations in either delay step, fundamental frequency follow a predetermined pattern, or can be detected then steps 40 and 50 are to be repeated accordingly.

In yet a further preferred embodiment of the invention, the variable delay period is the sum of a plurality of delay sub-periods. The length of each delay sub-period is controlled by at least one basic control signals out of the basic set of control signals. The combination of the basic set of control can vary either each clock cycle, vary randomly or in a predetermined manner.

FIG. 3 is a schematic description of an apparatus 100 for generating a spread spectrum clock signal. Apparatus 100 comprising: (A) variable delay line 110, for receiving a clock signal having a fundaments period T, delaying the clock signal for a variable delay period and providing the spread spectrum clock. Conveniently, the clock delay is changed by at least one delay step DS. (B) control unit 120, coupled to variable delay line 110, for receiving a control parameter R, R defining a relationship between the fundamental period T and a period offset DT. Control unit 120 is adapted to control the variable delay period of the variable delay line so that the spread spectrum clock has a period that ranges between (T-DT) and (T+DT). Conveniently, DT is much smaller than T, DT equals T*R.

Apparatus 100 further comprises of a learning unit 130, coupled to control unit 120, for receiving the clock signal and adjusting the delay step DS so that the spread spectrum clock signal to be produced during step (1.d) has a period that ranges between (T-DT) and (T+DT). Learning unit 130 can be activated either constantly, so that apparatus 100 allows a constant compensations for variations in its behavior or in the clock signal. If the variations in either delay step or fundamental frequency follow a predetermined pattern or can be detected, then learning unit 130 can be activated accordingly. Learning unit 130 learns the variations in the clock signal or in the behavior of apparatus 100 and alter delay step DS accordingly.

Control unit 120 sends variable delay line 110 a plurality of control signals for determining the variable delay period. Learning unit 130 is adapted to learn and to store at least one control word CW that causes variable delay line 110 to delay the clock signal by at least a delay step DS. The control word CW is further provided to control unit 120 and to variable delay line 110. Conveniently, learning unit 130 is adapted to learn a set of control words that cause variable delay line 110 to delay the clock signal by multiples of DS.

Control unit 120 further comprises of a pattern generator 121, a translation table 121. Pattern generator 121 generates a sequence of signals that have a predetermined pattern. This sequence is provided to translating table 121 that translates the sequence to a control word that defines the delay of the variable delay line. Conveniently, translation table 122 is updated by learning unit 130. These updates allow apparatus 100 to compensate for variations in T, DS or in the behavior of apparatus 100.

Preferably, pattern generator 121 comprises of a random number generator 129 and pattern counter 128. Random number generator 129 provides a random or a pseudo-random sequence of numbers to pattern counter 128. Such a generator can be implemented by a multi-bit register coupled to a plurality of XOR logic units. The context of pattern counter 128 is either decreased or increased accordingly.

Conveniently, the variable delay period is controlled by a combination of a basic set of control signals. Learning unit 130 is adapted to learn and store the basic set of control signals. Control unit 120 receives the basic set of control signals from learning unit 130 and provides the combination of the basic set of control signals to variable delay line 110.

Preferably, variable delay line 110 comprises of a plurality of serially coupled variable delay units 111-118, each variable delay unit delays a signal by a delay sub-period. The length of each delay sub-period is controlled by at least one basic control signals out of the basic set of control signals provided by control unit 120.

For example, assuming that a basic control signals BCS1, BSC2, BSC3 and BSC4 cause a delay unit to delay a signal by DS, 2*DS, 3*DS and 4*DS accordingly. Providing control word BSC1 to all delay units will cause variable delay line 110 to delay a clock signal by a delay period of 8*DS (DS+DS+DS+DS+DS+ DS+DS+DS+DS). Providing two control signals of each BSC1, BSC2, BSC4 and BSC4 to delay units 111 - 118 will cause variable delay line 110 to delay a clock signal by a delay period of 22*DS 2*(DS + 2*DS + 4*DS + 4*DS).

A portion of an exemplary translation table 122 is shown below :

| Input signal (output of pattern generator) | Translation table output signal |
|---|---|
| '00000' | 0,0,0,0,0,0,0,0 |
| '00001' | 0,0,0,0,BSC1,0,0,0 |
| '00010' | 0,0,0,BSC2,0,0,0,0 |
| '00011' | BSC3,0,0,0,0,0,0,0 |
| '00100' | 0,0,BSC4,0,0,0,0,0 |
| .. | .. |
| '00101' | 0,0,0,0,BSC4,BSC1,0,0 |
| '11100' | BSC4, BSC4, BSC4, BSC4, BSC4, BSC4. BSC4,0 |
| '11101' | BSC4, BSC4, BSC4, BSC4, BSC4, BSC4. BSC4,BSC1 |
| '11110' | BSC4, BSC4, BSC4, BSC4, BSC4, BSC4. BSC4, BSC2 |
| '11111' | BSC4, BSC4, BSC4, BSC4, BSC4, BSC4. BSC4, BSC3 |

Learning unit 130 adjusts BSC1, BSC2, BSC3 and BSC4 so that the provision of BSC1, BSC2, BSC3 and BSC4 to variable delay line 110 will result in changing the delay by multiples of delay step DS, even if the behavior of apparatus 100 or fundamental period T vary.

Learning unit 130 comprises of an emulation device 141 that emulates variable delay line 110, so that learning unit 130 can track after variations in the characteristics of variable delay line 110. Emulation device 141 generates an emulated signal that has a period that is controlled by a control word that is provided to emulation device. Learning unit 130 also comprises of comparing unit 142, that receives the clock signal and the emulated signal, compares these signals and provides control words to be provided to variable delay line 110 so that variations in either the clock signal or of the behavior of apparatus 100 do not alter the predetermined relationship R between a fundamental period T of a received clock signal and a delay offset DT.

The correlation between learning unit 130, variable delay line 110, and control unit 120 is better understood from the following example:

Delay line 110 comprises of eight delay units 111-118, each is controlled by a 16-bit control word. Basic control signals BCS1, BSC2, BSC3 and BSC4 cause a delay unit to delay a signal by DS, 2*DS, 3*DS and 4*DS accordingly. Learning unit 130 learns BSC1, BSC2, BSC3, BSC4 constantly, and alters them in a manner that compensates for variations in the behavior of apparatus 100.

Random number generator 129 provides a sequence of 16-bit numbers to pattern counter 128. Pattern counter 128 is a 5-bit up-down counter that count 'up' when a predetermined bit of the number provided by pattern generator 121 is "1" and counts 'down' when the bit is "0". Pattern counter 128 output signal is provided to translation table 128 that translates the output signal to a control word comprising of basic control signals. If pattern generator 128 output equals 11111 than delay line 110 receives a control word of BSC4, BSC4, BSC4, BSC4, BSC4, BSC4, BSC4, BSC4 indicating that the delay will be 16 delay steps. If pattern generator 128 output equals 00000 than delay line 110 receives a control word of 0,0,0,0,0,0,0,0 indicating that the clock signal will not be substantially delayed.

Comparing unit 142 comprises of first counter 143, second counter 144, first and second registers 145 and 146 and subtracting unit 147. Learning unit 130 is controlled by control signals from control unit 120 but also can be controlled by an internal control unit (not shown).

Emulation device 141 is a ring oscillator that has a controllable delay period ED. Conveniently, emulation device 141 comprises of an odd number of delay units, such as delay unit 111, 112, 113 or 114 serially coupled to each other, wherein the output of the last delay unit is coupled to the input of the first delay unit to form a ring. Preferably, a single delay unit is enough.

The controllable delay period ED is controlled by a control word that is provided by control unit 120. Emulation device 141 is initialized by setting ED to a first value ED1. The output of emulation device 141 is coupled to an input of first counter 143. First counter 143 is programmed to overflow each N0 counts. N0 is a programmable variable that is provided to first counter 143 by control unit 120. The output of first counter is coupled to an enable input of second counter 144. Second counter 144 receives the clock signal via another input. First counter 143 overflows after a period of ED1*N0 and when it overflows it sends a signal to second counter 144, causing second counter 144 to stop counting and to send its content N 1 to register 145. After N1 is stored, control unit 120 sends a control signal that changes the delay of emulation device 141 to a second value ED2. First counter 143 starts to count and overflows after a period of ED2*N0. When first counter overflows it sends a signal to second counter causing it to stop counting and to send its content N2 to subtracting unit 147. Subtracting unit 147 receives N1 from register 145, N2 from second counter 144 and R*N0 from register 146 and subtracting N0 and N0*R from N1. The product is provided to control unit 120 that either increases or decreases ED accordingly. For example, if controllable delay line 110 is controlled by a combination of basic control set BCS1, BSC2, BSC3 and BSC4 then the learning process is repeated four times. While BSC1, BSC2, BSC3 and BSC4 are learned, register 146 stores N0*R, 2*N0*R, 3*N0*R and 4*N0*R accordingly.

BSC1, BSC2, BSC3 and BSC4 are stored in register file, and are used to update translation table 122 of control unit 120.

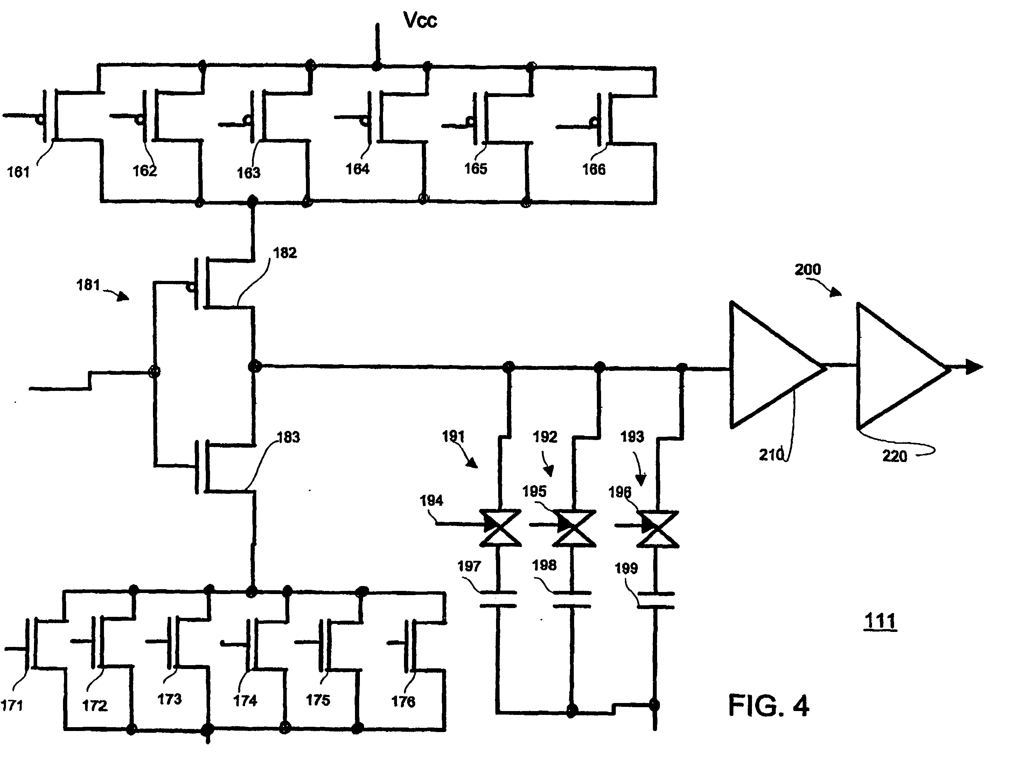

FIG. 4 is a schematic description of delay unit 111, according to a preferred embodiment of the invention.

Delay unit 111 comprises of a plurality of current sources 161-166, a plurality of current sinks 171 - 176, an inverter 181, a plurality of switched capacitors 191-193 and a driver unit 200. Driver unit 200 preferably comprises of a sense inverter 210 and a serially coupled buffer 220, sense inverter 210 is coupled to the output of the inverter and to one end of the parallel coupled switched capacitors 191-193, for sensing the voltage difference upon them.

Inverter 181 receives an input signal, and according to a portion of a control word either charges or discharges a plurality of switched capacitors, coupled in a parallel manner between the output of inverter 181 and the ground. Preferably, sensing inverter 210 is coupled to the output of inverter 181 so that when the voltage potential over the switched capacitors is above a first threshold, sense inverter outputs a delayed signal having a first logic value. When the voltage is below a second threshold, sense inverter 210 outputs a delayed signal having a second logic value.

Current sources 161-166 are implemented by p-channel MOS transistors, current sinks 171-176 are implemented by n-channel MOS transistors. Inverter 181 is implemented by a p-channel and an n-channel transistors 182 and 183. Switched capacitors 191- 193 are implemented by a plurality of transfer gates 194-196 that are coupled to a plurality of MOS capacitors 197 - 199. A transfer gate comprises of a p-channel and a n-channel transistor that either allow current to pass through the transfer gate or isolate the input of the transfer gate from its input.

Current sources 161 - 166 are coupled in a parallel manner between power supply Vcc and the drain of transistor 182. Current sinks 171 - 176 are coupled in a parallel manner between the ground and the drain of transistor 183. The gates of transistors 161 - 166 and 171 - 176 receive a portion of a control word. The control bits of the portion of the control word either activate or deactivate transistor and determine which current sources provide current to inverter 181 and which current sink 'rob' current from inverter 181. Transistors 161 - 166 and 171 - 176 determine the strength of current that either charges or discharged switched capacitors 191 - 193 that are coupled to the output of inverter 181. Another portion of the control word determines which capacitors are isolated and which switched capacitors are either charged or discharged by inverter 181. For example, BS is fifteen bits wide, six bits are used to control current sources 161 - 166, six bits are used to control six current drains 171 - 176 and three bits are used to control switched capacitors 191 - 193.

The control word controls the delay period by defining a capacitance to be charged/ discharged and the strength of a current that is used to charge/ discharge it.

Thus, there has been described herein an embodiment including at least one preferred embodiment of an improved method and apparatus for generating spread spectrum clock. It will be apparent to those skilled in the art that the disclosed subject matter may be modified in numerous ways and may assume many embodiments other than the preferred form specifically set out and described above. Accordingly, the above disclosed subject matter is to be considered illustrative and not restrictive, and to the maximum extent allowed by law, it is intended by the appended claims to cover all such modifications and other embodiments which fall within the true spirit and scope of the present invention.

## Claims

1. A method (10) for generating spread spectrum clock signals, the method comprising the steps of:
(20) determining a relationship R between a fundamental period T of a clock signal and a period offset DT;
(30) receiving the clock signal having the fundamental period T; and
(50) producing a spread spectrum clock signal having a period that ranges between (T-DT) and (T+DT); wherein DT = T*R and the step of producing a spread spectrum clock signal (50) involves delaying the clock signal by a variable delay period wherein the variable delay period is varied by at least one delay step DS **characterized in that** the step of receiving the clock signal (30) is followed by a step
(40) of adjusting the delay step DS so that the spread spectrum clock signal to be produced during the step of producing a spread spectrum clock signal (50) has a period that ranges between (T-DT) and (T+DT).

2. The method (10) of claim 1 wherein the variable delay period is varied randomly.

3. The method (11) of claim 1 or 2 wherein steps (40) and (50) are repeated either constantly, in a manner that compensated for variations in the delay step, in a manner that compensates for variations in the variable delay period or in a manner that compensates for changes in the fundamental period .

4. The method (11) of claim 1 wherein the spread spectrum clock generation involves passing the clock signal through a variable delay line (110), for delaying the clock signal for a variable delay period.

5. The method (11) of claim 4 wherein step (40) further comprising the steps of:
(42) generating a emulation signal by an emulator (141) of the variable delay line (110); and
(44) comparing the clock signal and the emulation signal and changing DS accordingly.

6. The method (10) of claim 4 wherein the variable delay period of the variable delay line is controlled by a control word; wherein step (40) further comprises the steps of:
(42) learning at least one control word CW that causes the variable delay line (110) to delay the clock signal by at least a delay step DS; and
(44) storing the at least one control word CW so that the at least one control word can be provided to the variable delay line (110) during step (50).

7. The method (11) of claim 1 wherein the variable delay period is controlled by a combination of a basic set of control signals and step (30) is followed by step (40) of learning and storing the basic set of control signals.

8. The method (11) of claim 7 wherein steps (40) and (50) are repeated either constantly, in a manner that compensated for variations in the delay step, in a manner that compensates for variations in the variable delay period or in a manner that compensates for changes in the fundamental period.

9. The method (10) of claim 1 wherein the variable delay period is the sum of a plurality of delay sub-periods and wherein the length of each delay sub-period is controlled by at least one basic control signals out of the basic set of control signals.

10. The method (10) of claim 7 wherein the combination of the basic set of control signals is varied randomly.

11. . An apparatus (100) for generating a spread spectrum clock signal, the apparatus comprising :
a variable delay line (110), for receiving a clock signal having a fundamental period T, delaying the clock signal for a variable delay period wherein the variable delay period is varied by at least one delay step DS and providing the spread spectrum clock;
wherein the variable delay period is controlled by a control unit (120);
wherein the control unit (120), coupled to the variable delay line (110), for receiving a control parameter R, R defining a relationship between the fundamental period T and a period offset DT, the control unit (120) is adapted to control the variable delay period of the variable delay line (110) so that the spread spectrum clock has a period that ranges between (T-DT) and (T+DT)**characterized in** a learning unit (130), coupled to the control unit (120), for receiving the clock signal and adjusting the delay step DS so that the spread spectrum clock signal to be produced has a period that ranges between (T-DT) and (T+DT)..

12. The apparatus (100) of claim 11 wherein the variable delay period is varied randomly.

13. The apparatus (100) of claim 11 wherein the variable delay period is varied each clock cycle by either increasing or decreasing the variable delay period by at least one delay step DS.

14. The apparatus (100) of claim 11 wherein the learning unit (130) comprising of:
an emulation device (141), for emulating the variable delay line (110), so that the learning unit (130) can track variations in the characteristics of variable delay line (110); wherein the emulation device (141) is adapted to receive the clock signal and delays it;
a comparing unit (142), for receiving the clock signal and the delayed clock signal, comparing them and providing control words that determine the delay step DS.

15. The apparatus (100) of claim 14 wherein the comparing unit (142) provides control words so that variations in either the clock signal or in characteristics of the apparatus do not alter the relationship R between a fundamental period T of the clock signal and the delay offset DT.

16. The apparatus (100) of claim 11 wherein the control unit (120) sends the variable delay line (110) a plurality of control signals for determining the variable delay period; and
wherein the learning unit (130) is adapted to learn and to store at least one control word CW that causes the variable delay line (110) to delay the clock signal by at least a delay step DS; and
wherein the control word CW is further provided to the control unit (120) and to the variable delay line (110).

17. The apparatus (100) of claim 11 wherein the variable delay period is controlled by a combination of a basic set of control signals; and
wherein the learning unit (130) is arranged to learn and store the basic set of control signals.

18. The apparatus (100) of claim 17 wherein the control unit (120) receives the basic set of control signals from the learning unit (130) and provides the combination of the basic set of control signals to the variable delay line (110).

19. The apparatus (100) of claim 11 wherein the variable delay line (110) comprises of a plurality of serially coupled variable delay units (111-118), each variable delay unit delays a signal by a delay sub-period; and
wherein the length of each delay sub-period is controlled by at least one basic control signals out of the basic set of control signals.

20. The apparatus (100) of claim 19 wherein the combination of the basic set of control signals is varied each clock cycle.

## Patentansprüche

1. Verfahren (10) zum Erzeugen von Spreizspektrum-Taktsignalen, wobei das Verfahren die Schritte umfasst:
(20) Bestimmen eines Verhältnisses R zwischen einer Fundamentalperiode T eines Taktsignals und einem Perioden-Offset DT;
(30) Empfangen des Taktsignals mit der Fundamentalperiode T; und
(50) Erzeugen eines Spreizspektrum-Taktsignals mit einer Periode, welche im Bereich zwischen (T-DT) und (T+DT) liegt; wobei DT=T*R und der Schritt des Erzeugens eines Spreizspektrum-Taktsignals (50) das Verzögern des Taktsignals um eine variable Verzögerungsperiode umfasst, wobei die variable Verzögerungsperiode durch wenigstens einen Verzögerungsschritt DS variiert wird,
**dadurch gekennzeichnet, dass** der Schritt des Empfangens des Taktsignals (30) gefolgt wird von einem Schritt (40) des Einstellens des Verzögerungsschrittes DS, so dass das während des Schrittes des Erzeugens eines Spreizspektrum-Taktsignals (50) zu erzeugende Spreizspektrum-Taktsignal eine Periode aufweist, welche im Bereich zwischen (T-DT) und (T+DT) liegt.

2. Verfahren (10) nach Anspruch 1, wobei die variable Verzögerungsperiode zufällig variiert wird.

3. Verfahren (11) nach Anspruch 1 oder 2, wobei die Schritte (40) und (50) entweder konstant, in einer Weise, welche Variationen in dem Verzögerungsschritt kompensiert, in einer Weise, welche Variationen in der variablen Verzögerungsperiode kompensiert, oder in einer Weise, welche Änderungen in der Fundamentalperiode kompensiert, wiederholt werden.

4. Verfahren (11) nach Anspruch 1, wobei die Spreizspektrum-Takterzeugung das Leiten des Taktsignals durch eine variable Verzögerungsleitung (110) zum Verzögern des Taktsignals um eine variable Verzögerungsperiode umfasst.

5. Verfahren (11) nach Anspruch 4, wobei Schritt (40) weiter die Schritte umfasst:
(42) Erzeugen eines Emulationssignals durch einen Emulator (141) der variablen Verzögerungsleitung (110); und
(44) Vergleichen des Taktsignals und des Emulationssignals und entsprechendes Ändern von DS.

6. Verfahren (10) nach Anspruch 4, wobei die variable Verzögerungsperiode der variablen Verzögerungsleitung durch ein Steuerwort gesteuert wird, wobei Schritt (40) weiter die Schritte umfasst:
(42) Lernen wenigstens eines Steuerwortes CW, welches die variable Verzögerungsleitung (110) veranlasst, das Taktsignal um mindestens einen Verzögerungsschritt DS zu verzögern; und
(44) Speichern des wenigstens einen Steuerwortes CW, so dass das wenigstens eine Steuerwort während Schritt (50) an die variable Verzögerungsleitung (110) geliefert werden kann.

7. Verfahren (11) nach Anspruch 1, wobei die variable Verzögerungsperiode durch eine Kombination eines Basissatzes von Steuersignalen gesteuert wird und Schritt (30) gefolgt wird von Schritt (40) des Lernens und Speicherns des Basissatzes von Steuersignalen.

8. Verfahren (11) nach Anspruch 7, wobei die Schritte (40) und (50) entweder konstant, in einer Weise, die Variationen in dem Verzögerungsschritt kompensiert, in einer Weise, die Variationen in der variablen Verzögerungsperiode kompensiert, oder in einer Weise, die Änderungen in der Fundamentalperiode kompensiert, wiederholt werden.

9. Verfahren (10) nach Anspruch 1, wobei die variable Verzögerungsperiode die Summe einer Mehrzahl von Verzögerungs-Subperioden ist und wobei die Länge jeder Verzögerungs-Subperiode von wenigstens einem Basissteuersignal aus dem Basissatz von Steuersignalen gesteuert wird.

10. Verfahren (10) nach Anspruch 7, wobei die Kombination des Basissatzes von Steuersignalen zufällig variiert wird.

11. Vorrichtung (100) zum Erzeugen eines Spreizspektrum-Taktsignals, wobei die Vorrichtung umfasst:
eine variable Verzögerungsleitung (110) zum Empfangen eines Taktsignals mit einer Fundamentalperiode T, zum Verzögern des Taktsignals um eine variable Verzögerungsperiode, wobei die variable Verzögerungsperiode um mindestens einen Verzögerungsschritt DS variiert wird, und zum Bereitstellen des Spreizspektrum-Taktes;
wobei die variable Verzögerungsperiode durch eine Steuereinheit (120) gesteuert wird;
wobei die mit der variablen Verzögerungsleitung (110) gekoppelte Steuereinheit (120) zum Empfangen eines Steuerparameters R, wobei R ein Verhältnis zwischen der Fundamentalperiode T und einem Perioden-Offset DT definiert, dient und wobei die Steuereinheit (120) eingerichtet ist, die variable Verzögerungsperiode der variablen Verzögerungsleitung (110) zu steuern, so dass der Spreizspektrum-Takt eine Periode aufweist, die im Bereich zwischen (T-DT) und (T+DT) liegt, **gekennzeichnet durch** eine mit der Steuereinheit (120) gekoppelte Lerneinheit (130) zum Empfangen des Taktsignals und zum Einstellen des Verzögerungsschrittes DS, so dass das zu erzeugende Spreizspektrum-Taktsignal eine Periode aufweist, die im Bereich zwischen (T-DT) und (T+DT) liegt.

12. Vorrichtung (100) nach Anspruch 11, wobei die variable Verzögerungsperiode zufällig variiert wird.

13. Vorrichtung (100) nach Anspruch 11, wobei die variable Verzögerungsperiode in jedem Taktzyklus entweder durch Erhöhen oder Erniedrigen der variablen Verzögerungsperiode um wenigstens einen Verzögerungsschritt DS variiert wird.

14. Vorrichtung (100) nach Anspruch 11, wobei die Lerneinheit (130) umfasst:
eine Emulationsvorrichtung (141) zum Emulieren der variablen Verzögerungsleitung (110), so dass die Lerneinheit (130) Variationen der Eigenschaften der variablen Verzögerungsleitung (110) verfolgen kann; wobei die Emulationsvorrichtung (141) eingerichtet ist, das Taktsignal zu empfangen und dieses verzögert;
eine Vergleichseinheit (142), um das Taktsignal und das verzögerte Taktsignal zu empfangen, diese zu vergleichen und Steuerworte zu liefern, welche den Verzögerungsschritt DS bestimmen.

15. Vorrichtung (100) nach Anspruch 14, wobei die Vergleichseinheit (142) Steuerworte liefert, so dass Variationen entweder im Taktsignal oder in Eigenschaften der Vorrichtung das Verhältnis R zwischen der Fundamentalperiode T des Taktsignals und dem Verzögerungs-Offset DT nicht ändert.

16. Vorrichtung (100) nach Anspruch 11, wobei die Steuereinheit (120) der variablen Verzögerungsleitung (110) eine Mehrzahl von Steuersignalen zum Bestimmen der variablen Verzögerungsperiode liefert; und
wobei die Lerneinheit (130) eingerichtet ist, wenigstens ein Steuerwort CW zu lernen und zu speichern, welches die variable Verzögerungsleitung (110) veranlasst, das Taktsignal um mindestens einen Verzögerungsschritt DS zu verzögern; und
wobei das Steuerwort CW weiter der Steuereinheit 120 und der variablen Verzögerungsleitung (110) bereitgestellt wird.

17. Vorrichtung (100) nach Anspruch 11, wobei die variable Verzögerungsperiode durch eine Kombination eines Basissatzes von Steuersignalen gesteuert wird; und
wobei die Lerneinheit (130) eingerichtet ist, den Basissatz von Steuersignalen zu lernen und zu speichern.

18. Vorrichtung (100) nach Anspruch 17, wobei die Steuereinheit (120) den Basissatz von Steuersignalen von der Lerneinheit (130) empfängt und die Kombination des Basissatzes von Steuersignalen an die variable Verzögerungsleitung (110) liefert.

19. Vorrichtung (100) nach Anspruch 11, wobei die variable Verzögerungsleitung (110) eine Mehrzahl von seriell gekoppelten variablen Verzögerungseinheiten (111-118) umfasst, wobei jede variable Verzögerungseinheit ein Signal um eine Verzögerungs-Subperiode verzögert; und
wobei die Länge jeder Verzögerungs-Subperiode durch wenigstens ein Basissteuersignal aus dem Basissatz von Steuersignalen gesteuert wird.

20. Vorrichtung (100) nach Anspruch 19, wobei die Kombination des Basissatzes von Steuersignalen in jedem Taktzyklus variiert wird.

## Revendications

1. Procédé (10) de génération de signaux d'horloge à spectre étalé, le procédé comprenant les étapes qui consistent à :
(20) déterminer une relation R entre une période fondamentale T d'un signal d'horloge et un décalage de période DT ;
(30) recevoir le signal d'horloge ayant la période fondamentale T ; et
(50) produire un signal d'horloge à spectre étalé ayant une période qui varie entre (T - DT) et (T + DT) ; où DT = T * R, et l'étape de production d'un signal d'horloge à spectre étalé (50) met en jeu l'introduction d'un temps de retard variable dans le signal d'horloge, le temps de retard variable étant modifié d'au moins un pas de retard DS, **caractérisé en ce que** l'étape de réception du signal d'horloge (30) est suivie par une étape (40) qui consiste à ajuster le pas de retard DS de telle sorte que le signal d'horloge à spectre étalé destiné à être produit pendant l'étape de production d'un signal d'horloge à spectre étalé (50) ait une période qui varie entre (T - DT) et (T + DT).

2. Procédé (10) selon la revendication 1, dans lequel le temps de retard variable est modifié d'une manière aléatoire.

3. Procédé (11) selon la revendication 1 ou 2, dans lequel les étapes (40) et (50) sont répétées d'une manière constante, d'une manière qui compense les variations du pas de retard, d'une manière qui compense les variations du temps de retard variable, ou bien d'une manière qui compense les changements de la période fondamentale.

4. Procédé (11) selon la revendication 1, dans lequel la génération d'une horloge à spectre étalé met en jeu l'envoi du signal d'horloge à travers une ligne à retard variable (110), pour l'introduction d'un temps retard variable dans le signal d'horloge.

5. Procédé (11) selon la revendication 4, dans lequel l'étape (40) comprend, en outre, les étapes qui consistent à :
(42) générer un signal d'émulation par un émulateur (141) de la ligne à retard variable (110) ; et
(44) comparer le signal d'horloge et le signal d'émulation, et modifier DS en conséquence.

6. Procédé (10) selon la revendication 4, dans lequel le temps de retard variable de la ligne à retard variable est commandé par un mot de commande ; l'étape (40) comprenant, en outre, les étapes qui consistent à :
(42) apprendre au moins un mot de commande CW qui entraîne la ligne à retard variable (110) à retarder le signal d'horloge d'au moins un pas de retard DS ; et
(44) stocker l'au moins un mot de commande CW de telle sorte que l'au moins un mot de commande puisse être envoyé à la ligne à retard variable (110) pendant l'étape (50).

7. Procédé (11) selon la revendication 1, dans lequel le temps de retard variable est commandé par une combinaison d'un ensemble de signaux de commande de base, et l'étape (30) est suivie par l'étape (40) qui consiste à apprendre et stocker l'ensemble de signaux de command de base.

8. Procédé (11) selon la revendication 7, dans lequel les étapes (40) et (50) sont répétées d'une manière constante, d'une manière qui compense les variations du pas de retard, d'une manière qui compense les variations du temps de retard variable, ou bien d'une manière qui compense les changements de la période fondamentale.

9. Procédé (10) selon la revendication 1, dans lequel le temps de retard variable est égal à la somme d'une pluralité de sous-périodes de retard, et dans lequel la longueur de chaque sous-période de retard est commandée par au moins un signal de commande de base de l'ensemble de signaux de commande de base.

10. Procédé (10) selon la revendication 7, dans lequel la combinaison de l'ensemble de signaux de commande de base est modifiée d'une manière aléatoire.

11. Appareil (100) pour générer un signal d'horloge à spectre étalé, l'appareil comprenant :
une ligne à retard variable (110), destinée à recevoir un signal d'horloge ayant une période fondamentale T, à retarder le signal d'horloge d'un temps de retard variable, le temps de retard variable étant modifié d'au moins un pas de retard DS, et à émettre l'horloge à spectre étalé ;
le temps de retard variable étant commandé par une unité de commande ( 120) ;
l'unité de commande (120) étant couplée à la ligne à retard variable (110) de façon à recevoir un paramètre de commande R, R définissant une relation entre la période fondamentale T et un décalage de période DT, l'unité de commande (120) étant conçue pour commander le temps de retard variable de la ligne à retard variable (110), de telle sorte que l'horloge à spectre étalé ait une période qui varie entre (T - DT) et (T + DT), **caractérisé en ce qu'**une unité d'apprentissage (130) est couplée à l'unité de commande (120) de façon à recevoir le signal d'horloge et à ajuster le pas de retard DS de telle sorte que le signal d'horloge à spectre étalé destiné à être produit ait une période qui varie entre (T - DT) et (T + DT).

12. Appareil (100) selon la revendication 11, dans lequel le temps de retard variable est modifié d'une manière aléatoire.

13. Appareil (100) selon la revendication 11, dans lequel le temps de retard variable est modifié d'au moins un pas de retard DS, à chaque cycle d'horloge, par augmentation ou bien diminution du temps de retard variable.

14. Appareil (100) selon la revendication 11, dans lequel l'unité d'apprentissage (130) comprend :
un dispositif d'émulation (141) destiné à émuler la ligne à retard variable (110) de telle sorte que l'unité d'apprentissage (130) puisse suivre les variations des caractéristiques de la ligne à retard variable (110) ; le dispositif d'émulation (141) étant conçu pour recevoir le signal d'horloge et le retarder ;
une unité de comparaison (142) destiné à recevoir le signal d'horloge et le signal d'horloge retardé, à les comparer et à produire des mots de commande qui déterminent le pas de retard DS.

15. Appareil (100) selon la revendication 14, dans lequel l'unité de comparaison (142) produit des mots de commande de telle sorte que les variations du signal d'horloge ou bien des caractéristiques de l'appareil ne modifient pas la relation R entre une période fondamentale T du signal d'horloge et le décalage de retard DT.

16. Appareil (100) selon la revendication 11, dans lequel l'unité de commande (120) envoie à la ligne à retard variable (110) une pluralité de signaux de commande pour déterminer le temps de retard variable ; et
dans lequel l'unité d'apprentissage (130) est adaptée pour apprendre et stocker au moins un mot de commande CW, qui entraîne la ligne à retard variable (110) à retarder le signal d'horloge d'au moins un pas de retard DS ; et
dans lequel le mot de commande CW est, en outre, envoyé à l'unité de commande (120) et à la ligne à retard variable (110).

17. Appareil (100) selon la revendication 11, dans lequel le temps de retard variable est commandé par une combinaison d'un ensemble de signaux de commande de base ; et
dans lequel l'unité d'apprentissage (130) est conçue pour apprendre et stocker l'ensemble de signaux de commande de base.

18. Appareil (100) selon la revendication 17, dans lequel l'unité de commande (120) reçoit l'ensemble de signaux de commande de base en provenance de l'unité d'apprentissage (130) et envoie la combinaison de l'ensemble de signaux de commande de base à la ligne à retard variable (110).

19. Appareil (100) selon la revendication 11, dans lequel la ligne à retard variable (110) comprend une pluralité d'unités à retard variable (111 - 118) couplées en série, chaque unité à retard variable retardant un signal d'une sous-période de retard ; et
dans lequel la longueur de chaque sous-période de retard est commandée par au moins un signal de commande de base de l'ensemble de signaux de commande de base.

20. Appareil (100) selon la revendication 19, dans lequel la combinaison de l'ensemble de signaux de commande de base est modifiée à chaque cycle d'horloge.
